# EUROPÄISCHE PATENTSCHRIFT

(11) **EP 0 874 787 B1**
(45) Veröffentlichungstag und Bekanntmachung des Hinweises auf die Patenterteilung: **11.08.1999**
(21) Anmeldenummer: 96941039.8
(22) Anmeldetag: 27.11.1996
(51) Int. Cl.: C04B 35/45, C04B 35/653, H01L 39/24

(54) **VERFAHREN ZUR HERSTELLUNG VON OPTIMIERTEN, SCHMELZTEXTURIERTEN VOLUMENPROBEN AUF DER BASIS DES HOCHTEMPERATURSUPRALEITERS YBa2Cu3O7 (YBCO)**
PROCESS FOR PRODUCING OPTIMIZED MELT-TEXTURED VOLUME PROBES BASED ON THE HIGH-TEMPERATURE SUPERCONDUCTOR YBa2Cu3O7 (YBCO)
PROCEDE DE PRODUCTION D'ECHANTILLONS VOLUMIQUES TEXTURES PAR FUSION OPTIMISES, A BASE DU SUPRACONDUCTEUR HAUTE TEMPERATURE YBa2Cu3O7 (YBCO)

(30) Priorität: 19.01.1996 DE 19601771
(43) Veröffentlichungstag der Anmeldung: 04.11.1998
(73) Patentinhaber: Forschungszentrum Karlsruhe GmbH, 76133 Karlsruhe (DE)
(72) Erfinder: BORNEMANN, Hans-Jürgen, D-75365 Calw (DE); BURGHARDT, Thomas, D-75331 Engelsbrand (DE); HENNIG, Wolfgang, D-76185 Karlsruhe (DE)
(74) Vertreter: Rückert, Friedrich, Dr.
(86) Internationale Anmeldenummer: EP9605234
(87) Internationale Veröffentlichungsnummer: WO9726224

(56) Entgegenhaltungen:
- EP-A- 0 517 469
- EP-A- 0 537 363
- DE-A- 4 324 088
- APPLIED PHYSICS LETTERS, Bd. 26, 1992, Seiten 3313-3315, XP000281275 V. SELVAMANICKAM ET AL.: "Control of grain alignment to fabricate long Y-Ba-Cu-O superconductors with high current density" in der Anmeldung erwähnt

## Beschreibung

Die Erfindung betrifft ein Verfahren zur Herstellung von Volumenproben auf der Basis des Hochtemperatursupraleiters YBa₂Cu₃O₇ (YBCO).

Diese Proben werden für berührungsfreie, selbststabilisierende, supraleitende Magnetlager verwendet. Bei solchen Lagern entsteht keine Reibung und kein Verschleiß von sich gegeneinander bewegenden Lagerteilen, da sie sich im Betrieb nicht unmittelbar berühren. Dadurch werden die mit herkömmlichen Lagern verbundenen betriebstechnischen Schwierigkeiten vermieden. Supraleitende Magnetlager sind selbststabilisierend und kommen daher ohne aufwendige Regelelektronik aus. Im Vergleich mit konventionellen Magnetlagern sind sie wesentlich einfacher im Aufbau und weniger kostenintensiv.

Aus der Anwendung ergeben sich eine Reihe von Anforderungen an das Material. Durch die spezielle Technik der Schmelztexturierung kann so ein Baustein hergestellt werden, der für solche Lageranwendungen geeignet ist. Mit ihm können hohe Levitationskräfte unter Aufrechterhaltung großer Lagerstabilität erzeugt werden.

Durch eine ausgerichtete Textur mit großen texturierten Bereichen (Korngröße > 3 cm) werden die supraleitenden Eigenschaften derart, daß im Betrieb Magnetfelder eingefroren werden können, mit denen diese Eigenschaften unkompliziert erreicht werden. Mikrostrukturelle Defekte bewirken eine effektivere Verankerung des magnetischen Flusses, bekannt unter dem Begriff "pinning", und damit die ausgezeichneten Stabilisierungseigenschaften des Lagers. Aufgrund der Anisotropie der kritischen Ströme des Hochtemperatursupraleiters YBCO ist für eine hohe Levitationskraft die Ausrichtung der c-Achse parallel zum externen Magnetfeld wichtig.

Eine grundsätzliche Anforderung hinsichtlich der technischen Fertigung ist jedoch zur Zeit noch nicht erfüllt, nämlich daß diese Lagerkomponenten wirtschaftlich und mit vertretbaren Ausschußstückzahlen gefertigt werden können. Erst dann werden solche Lager Verbreitung finden und in extrem schnell laufenden Rotoren, wie Turbomolekularpumpen oder Schwungradspeichern, leistungsverbessernd eingesetzt werden.

So ist in der DE 42 43 053 A1 ein Verfahren zur Herstellung voluminöser Oxidsupraleiter durch dreidimensionale Anordnung von Schichten REBa₂Cu₃O₇ beschrieben. RE ist irgend ein Seltene Erde Element. Das Verfahren besteht aus einer Vielzahl von langwierigen und und komplizierten Handhabungsschritten Schritten, wie Herstellen der intermediären Formkörper, mehrmaliges Aufheizen und Abkühlen, und verwendet neben Y verschiedene Elemente aus der Reihe der Seltene Erde, die alle zum Teil deutlich seltener sind als Y.

Das Verfahren ist geeignet, gute Endprodukte zu produziern, scheidet aber aus, industrielle Produktion automatisiert und wirtschaftlich zu betreiben.

Auch in der EP 0 486 698 A1 wird beschrieben, durch schichtartige Anordnung von RE 123 Phasen, die, wie oben in der DE 42 43 053 A1 beschrieben, in einer ganz bestimmten Reihenfolge angeordnet sein müssen, große , einkristalline Pellets zu erzeugen.

Es existieren Verfahren in den USA und Japan zur Erzeugung solcher Supraleiter.

In der US 4,990,493 wird ein Verfahren zur Herstellungeines orientierten, polykristallinen Supraleiters auf Basis der Verbindung Y-123 beschrieben. Selbst wenn dabei die einzelnen Körner orientiert sind, eignet sich polykristallines Y-123 nicht für Levitationsanwendungen, da der kritische Strom, hier auch "Intragrain- oder "Intergrain-Strom" genannt, auf die einzelnen Körner beschränkt ist. Diese Körper liegen bestenfalls im Bereich von 100 µm. Dadurch ist die integrale, über das ganze Pellet gemittelte Stromdichte viel zu klein und daher das Levitationsvermögen für praktische Anwendungen unbedeutend.

In USA setzt man verstärkt auf ein Gradientenverfahren (siehe V. Selvamanickam et al., Appl. Phys. Lett. 60. (1992) 3313 - 3315). Dazu wird das Supraleitermaterial in einem Gradientenofen geschmolzen und texturiert. Während dieses Verfahren Materialien mit guten supraleitenden Eigenschaften liefert, wie die o.e. hohe Levitationskraft und ausreichende Lagerstabilität, ist eine industrielle Produktion in wirtschaftlichem Rahmen so bis heute nicht durchführbar. In seiner Gesamtheit handelt es sich nämlich um ein zeitlich sehr langwieriges, aufwendiges und kompliziertes Verfahren mit folgenden, unbedingt einzuhaltenden Berücksichtigungen:
- Der Temperaturgradient muß genau einstellbar sein. Dafür werden teure Öfen mit aufwendiger Regelelektronik benötigt.
- Es kann immer nur eine Probe im Temperaturgradienten texturiert werden.
- Bisher werden immer nur verhältnismäßig kleine Proben gefertigt (< 3 cm) da man durch die Innenbohrung handelsüblicher Gradientenöfen beschränkt ist.
- Die erforderliche Reproduzierbarkeit konnte bisher nicht erreicht werden, d. h. es wird mit diesem Schmelz- und Texturierverfahren immer noch zu viel Ausschuß produziert.

Das in Japan favorisierte Melt-Powder-Melt-Growth-Verfahren (MPMG) (US 5,395,820) liefert wohl gute Materialien, kommt aber industriell wegen nicht einzuhaltender wirtschaftlicher Maßgaben nicht in Frage. Bei diesem japanischen Verfahren werden gepreßte Rohlinge zunächst bei sehr hohen Temperaturen, ca 1400 °C, geschmolzen und abgeschreckt, bevor der eigentliche Schmelztexturprozeß beginnt. Das ist mit einem arbeitsintensiven Fertigungschritt verbunden, der eine aufwendige und teure Ausrüstung, mit dem Hochleistungsofen beginnend, und eine Vorrichtung zum Abschrecken der 1400° C heißen Schmelze verlangt. Es ist gegenwärtig unklar, wie dieses Verfahren automatisierbar ist.

Daraus ergibt sich die Aufgabe, die der Erfindung zugrunde liegt. Es soll ein Verfahren bereitgestellt werden, mit dem Hochtemperatur-Supraleiter-Materialien der eingangs aufgeführten Zusammensetzung unter Einhaltung hoher Maßhaltigkeit, in einem automatisierten Prozeß in hohen Stückzahlen wirtschaftlich hergestellt werden können.

Das Verfahren wird erfindungsgemäß durch die im Anspruch 1 aufgeführten Verfahrensschritte gelöst. Bei dem Verfahren handelt es sich um ein für solche thermischen Prozesse einfaches, schnelles Verfahren mit großem Automatisierungspotential. Das Verfahren liefert bei guter Reproduzierbarkeit Materialien mit supraleitenden Eigenschaften, mit denen im Betrieb die erforderlichen Kraftzustände und Kraftfeldkonfigurationen in notwendiger Qualität erreicht werden. Durch das spezielle Keimverfahren ist es prinzipiell möglich, jede beliebige Textur oder eine gezielte Kombination von Vorzugsrichtungen in den Proben einzustellen und den Keimling nach der thermischen Behandlung zum mehrmaligen Wiedergebrauch von dem schmelztexturierten Supraleiter ohne Zerstörung abzunehmen. Stückzahlerhöhung ist z. B. ohne weiteres möglich, indem Öfen parallel betrieben werden und somit Proben gleichzeitig im Ofen texturiert werden können.

Ein abschließender wesentlicher Verfahrensschritt ist das Austauschen der Atmosphäre im oder das Fluten des Ofeninnern mit Sauerstoff und das Halten der Temperatur über eine vorgegebene Zeit vor dem endgültigen Abkühlen auf die Umgebungstemperatur. Hierdurch wird eine vollständige Oxidation in möglichst kurzer Zeit erreicht.

Mit dem Verfahren hergestellte Proben wurden bisher in verschiedenen supraleitenden Magnetlagern mit Erfolg eingesetzt. So wurde ein solches Lager in einen Schwungradenergiespeicher erprobt. Dieser Speicher ist mit einer Energiekapazität von 5 Wh und einer Leistung von 1 kVA noch verhältnismäßig klein. Proben für einen größeren Energiespeicher (300 Wh, 10 kVA) werden in Verbindung mit regenerativen Energieträgern, wie Windenergie und Photovoltaik, eingesetzt.

Für die möglichst reibungsfreie Lagerung in einem Rotationsscheiben-Vakuumsensor wurde mit den durch das Verfahren hergestellten YBCO-Proben ein Lager gebaut, mit dem die bislang geringste Reibung in einem supraleitenden Magnetlager erreicht wurde. Der Reibungskoeffizient betrug µ = 1.6*10⁻⁹.

Da die so hergestellten Materialien die Fähigkeit besitzen, magnetischen Fluß zu verankern, können sie als supraleitende Permanentmagnete eingesetzt werden. Die Materialien sind im Vergleich zu den besten konventionellen Permanentmagneten sehr viel leistungsfähiger. Der Einsatz als Hochleistungsmagnete bietet sich auch in kompakten und leistungsstarken Gleichstrommotoren oder in der Magnetfeldformung, medizinische Kernspinresonanz, an.

Durch die Fähigkeit, den magnetischen Fluß zu verankern, sind die Materialien in der Lage, hohe elektrische Ströme zu transportieren. Dadurch können sie z. B. in der Energietechnik als Stromzuführungen für Kryosysteme eingesetzt werden.

Im folgenden soll der Schmelzprozeß, wie er in Anpruch 1 mit dem Temperaturdiagramm dargestelllt ist, näher beschrieben werden. Die Zeichnung mit den Figuren 1 bis 3 veranschaulichen den Prozeß bzw. die erzielten Resultate.

Es zeigen:
Figur 1 die Wachstumsrichtung der erstarrenden Phase,
Figur 2 ein gemäß dem Verfahren schmelztexturiertes Pellet,
Figur 3 den Verlauf der Levitationskraft in Achsrichtung,

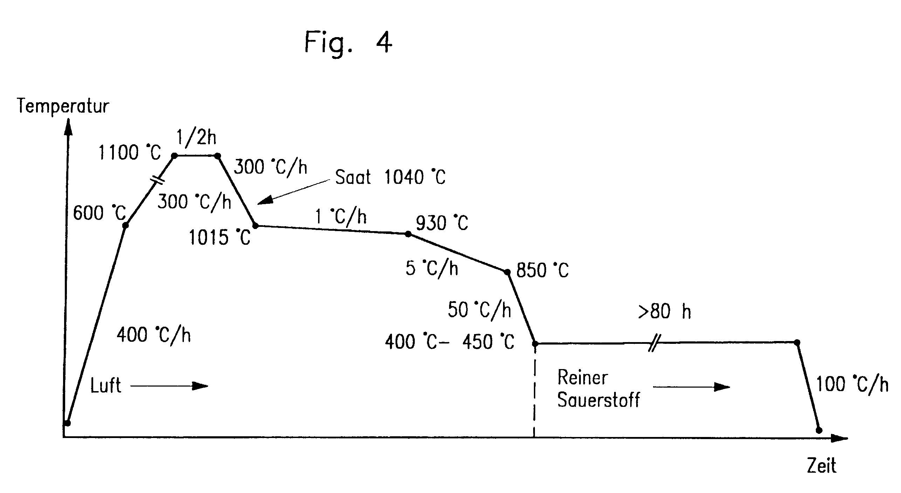

Figur 4 zeitlicher Verlauf der Schmelztexturierung.

Der Temperaturverlauf gemäß dem Temperatur-Zeit-Diagramm von Anspruch 1 hat sich insgesamt als optimal hinsichtlich der Zeit und der hohen Reproduzierbarkeit bei der Herstellung der Schmelztexturen herausgestellt.

In einem Isothermalofen mit würfelförmiger Heizkammer, bei dem nur die vier Seiten beheizt werden, und der erheblich größeren Dimension als die Pellets, nämlich 150 x 150 x 150 mm³ (LxBxH), werden die Pellets auf Al₂O₃-Stäbe gelegt und dem thermischen Prozeß ausgesetzt. Dieser beginnt mit einem ersten Erwärmungsschritt von Umgebungstemperatur auf 600 °C in anderthalb Stunden. Ab dann verläuft der zeitliche Temperaturanstieg langsamer, und zwar auf 1100 °C in 1,6 Stunden. Diese Hochheizphase muß rasch durchlaufen werden, um den Sauerstoffverlust in den Pellets minimal zu halten.

Der Hochheizphase folgt eine kurze Zeit mit konstanter Temperatur. Wichtig dabei ist, daß der Übergang zu dieser Phase ohne ein Temperaturüberschwingen über 10 °C von der letzten, langsameren Hochheizphase her erfolgt. Bei diesem Temperaturplateau besteht die peritektische Phase, das Pellet ist dabei in einem zweiphasigen Zustand, nämlich dem festen und dem flüssigen.

Nach dieser Plateau-Zeit wird die Temperatur mit einer Geschwindigkeit von 300 °C/h abgesenkt. Wird die Temperatur von 1040 °c erreicht, wird der Saatkristall auf das Pellet gesetzt, um den Kristallisationsprozeß zu induzieren. Diese erste Abkühlung geht bis 1015 °C weiter.

Ab 1015 °C setzt eine sehr langsame Abkühlphase ein, nämlich nur um 1 °C/h. In dieser Phase erfolgt das Kornwachstum, das etwa 85 h dauert. Danach erfogt die Temperaturabsenkung etwas schneller, nämlich um 5 °C/h von 930 auf 850 °C. Während dieser rascheren Abkühlung findet die Reaktion der Restschmelze statt. Bei 850 °C ist diese Reaktion abgeschlossen. Die Abkühlung wird jetzt beschleunigt, sie wird mit 50 °C/h vorangetrieben, bis 450 - 400 °C erreicht sind.

Die Temperatur wird jetzt wieder konstant gehalten, der Ofen, der bisher Luft als Atmosphäre hatte, wird mit reinem Sauerstoff geflutet. Das Pellet wird dadurch mit Sauerstoff beladen. Dieses zweite Temperaturplateau wird mindestens 80 h aufrechterhalten. 100 h haben sich für diese Phase als optimalen Zeitaufwand erwiesen.

Der letzte Temperaturabfall mit etwa 100 °C/h auf Zimmertemperatur beendet schließlich den Wärmebehandlungs- oder Schmelztexturierungsprozeß.

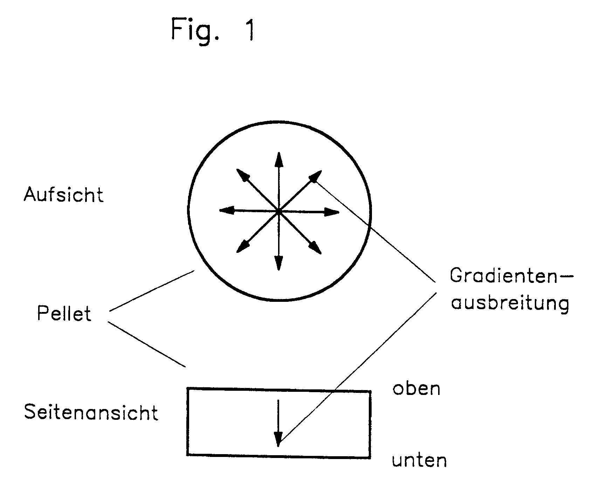

Bei dem Schmelzprozeß stellt sich ein radialer, rotationssymmetrischer Temperaturgradient ein. Dieser wird überlagert von einem weiteren (kleineren) Temperaturgradienten in Richtung der Zylinderachse (c-Achse) des Pellets. Die Kristallisation erfolgt von der Mitte der Oberseite radial nach außen und in die Tiefe des Pellets, wie in Figur 1 schematisch angedeutet. Die Oberseite des Pellets ist immer die am besten texturierte Fläche des Pellets. Die Orientierung wird durch den Saatkristall so hervorgerufen, daß sich die c-Achse parallel zur Zylinderachse einstellt. Es sind auch andere einstellbar, je nach Orientierung des Saatkristalls.

Für die Saatkristalle, die bei der Saattemperatur von 1040 °C gesetzt werden, muß bei diesem Schmelztexturierungverfahren eingehalten werden, daß ihre Kantenlänge senkrecht zur c-Achse > 2 mm und das Verhältnis Kante zu Höhe > 2 beträgt. Die Höhe sollte dabei mindestens 1 mm sein.

Bei dem Kammerofen sind die vier Seitenwände beheizt. Um Verunreinigungen der Proben durch Reaktion mit dem Tiegelmaterial zu vermeiden, werden sie auf den oben erwähnten Stäben aus Aluminiumoxid gesetzt. Die Stäbe sind beispielsweise etwa 100 mm lang und haben einen Durchmesser von etwa 4 mm. Dadurch bleibt die Berührungsfläche der Pellets minimiert.

Das Ankeimen mit dem Saatkristall wird während des Texturvorganges gemäß dem beschriebenen Programm bei 1040 °C begonnen. Hierzu wird der Ofendeckel geöffnet und der Saatkristall von oben auf die noch weiche Probe gedrückt. Entscheidend ist, daß sich der Saatkristall nicht von Anfang an, also schon zu Beginn der Hochheizphase, auf der Probe befindet, sondern erst beim ersten Abkühlvorgang beim Erreichen der 1040 °C, der Saattemperatur, gesetzt wird. Der Saatkristall würde sich sonst aufgrund des Überschreitens seiner Schmelztemperatur teilweise lösen.

Die Saatkristalle müssen dem YBCO strukturmäßig sehr ähnlich sein und außerdem einen höheren Schmelzpunkt besitzen. Sie werden in einem separaten Texturprozeß aus kommerziell erhältlichen Pulvern gemäß folgendem Ausgangsgemisch hergestellt:

YBa₂Cu₃O₇ + 0.3 mol% Sm₂O₃

Hierbei werden kleinere Proben mit einem Durchmesser von 20mm hergestellt. Das Temperaturprogramm ist das beschriebene, allerdings mit der Modifikation, daß die höchste Temperatur 1150 °C beträgt, und der erste langsame Kühlvorgang bei 1060 °C beginnt. Die Atmosphäre während des Schmelztexturvorgangs ist Luft. Es lassen sich auch Saatkristalle in einer Inertgasatmosphäre wie Argon züchten, hierfür ist das Ausgangsgemisch folgendermaßen anzusetzen:

YBa₂Cu₃O₇ + 0.3 mol% Sm₂O₃

Bei diesem Verfahren entstehen Körner von mehreren mm Durchmesser. Unter dem Lichtmikroskop wird ihre Orientierung festgestellt und danach gut texturierte Bereiche mit der gewünschten Orientierung mit der Diamantsäge herausgeschnitten und als Saatkristalle verwendet.

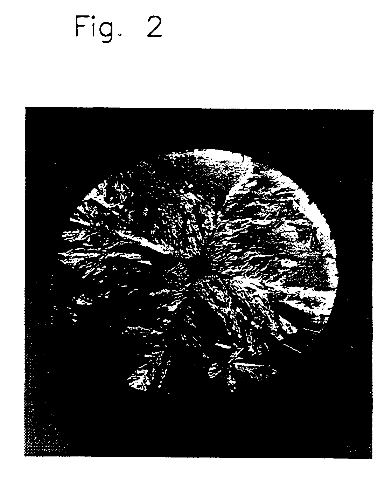

Figur 2 zeigt die Oberflächenstruktur eines zylindrischen, schmelztexturierten Pellets von 40 mm im Durchmesser und 15 mm Höhe. Sie ist einer Photographie entnommen. Das Pellet besteht aus einem Korn mit der c-Achse parallel zur Zylinderachse. Der Saatkristall ist an dem kleinen dunklen Viereck im Zentrum zu erkennen.

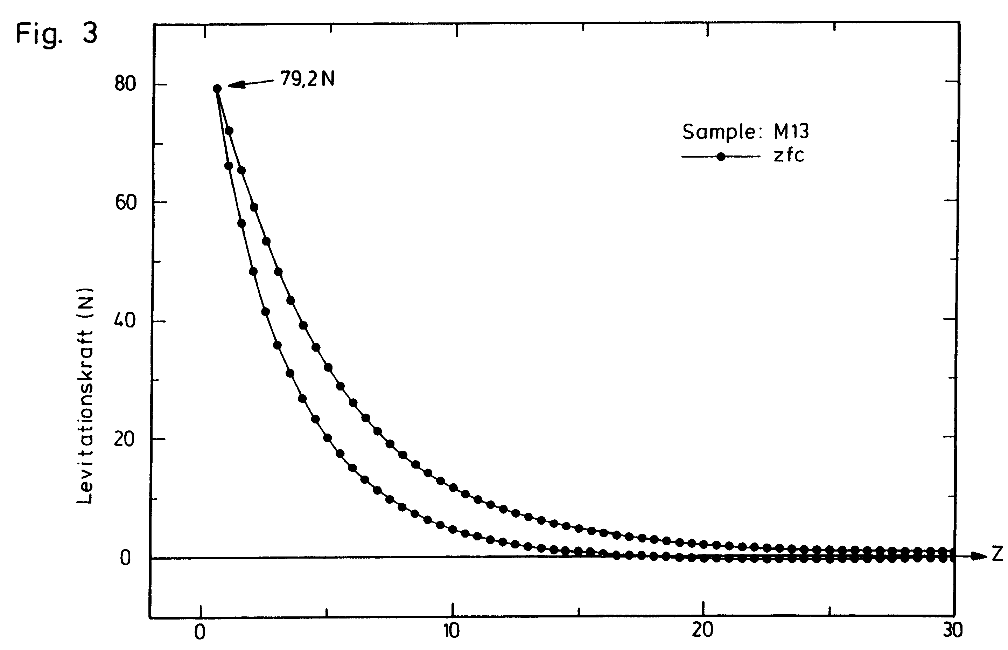

Nachweislich haben Pellets, die mit Hilfe von Saatkristallen texturiert wurden, bessere Levitationseigenschaften, als konventionell hergestellte Proben. Figur 3 zeigt den Verlauf der Levitationskraft in Abhängigkeit von der axialen Distanz (z-Achse). Eine solche Stärke der Levitationskraft wird mit konventionell hergestellten Pellets nicht erreicht.

## Patentansprüche

1. Verfahren zur Herstellung von optimierten, schmelztexturierten Volumenproben auf der Basis des Hochtemperatursupraleiters YBa₂Cu₃O₇ (YBCO) für die Anwendung in berührungsfreien, selbststabilisierenden Magnetlagern, das aus folgenden Verfahrensschritten besteht,
a) Vorbereiten des Ausgangsmaterials:
als Ausgangspulver wird kommerziell erhältliches Pulver der Verbindungen YBa₂Cu₃O₇₋ₓ, Y₂O₃ und PtO₂ gemahlen, und zwar derart, daß das YBa₂Cu₃O₇-Pulver eine Korngröße im Bereich von d₅₀ = 10 ± 2 µm hat und damit die spezifische Oberfläche etwa 1 ± 0.2 m²/g beträgt, wobei der Sauerstoffgehalt x < 0.2 und der Fremdphasenanteil < 1 % beträgt, Kohlenstoff höchstens mit 2000 ppm und die Übergangsmetalle allenfalls in der Summe mit höchstens 2000 ppm auftreten,
das Y₂O₃-Pulver eine Korngröße im Bereich von d = 4,5 µm und
das PtO₂-Pulver eine Korngröße im Bereich von d = 60 µm hat,
b) Mengenbereitstellung für die gewünschte Texturierung:
die drei Pulversorten werden für einen optimalen Texturierungsprozeß in Anteilen gemäß der Stöchiometrie der Verbindung
YBa₂Cu₃O₇ + 0.35 mol% Y₂O₃ + 0.1 Gew% PtO₂
weiterverarbeitet und in einer Kugelmühle innerhalb einer vorgegebenen Zeit bis zum Erreichen einer gleichmäßigen Vermengung durchmischt, wobei die Durchmischungszeit bis zu einer störenden CO₂-Aufnahme begrenzt wird, oder die drei Pulversorten werden unter einer Inertgasatmosphäre in der Kugelmühle bis zum Erreichen der vorgesehenen gleichmäßigen Vermengung durchmischt, das vorbereitete Pulver wird uniaxial in eine vorgegebene Form gepreßt und unter hohem Druck von mindestens 300 bar in Rohlinge vorgegebener Form verdichtet,
die Rohlinge werden zum Schutz vor Kontamination an ihrer Oberfläche verpackt und durch kaltes, isostatisches Pressen mit mindestens 3 000 bar weiter verdichtet, wodurch die Pulverkörner in einen engen Kontakt kommen,
c) Schmelzprozeß:
die Rohlinge werden gemäß dem zeitlich vorgegebenen Temperaturverlauf nach Figur 4 in einem Isothermalkammerofen texturiert,
während der Phase des ersten zeitlichen Temperaturabfalls bei einer vorgegebenen Temperatur, der Saattemperatur, werden Saatkristalle in situ in die Schmelze eingebracht,
vor der Abkühlungphase auf die Umgebungstemperatur wird die Temperatur im Innern des Ofens eine vorgebene Zeit konstant gehalten und der Ofen zu Beginn dieses Prozesses mit reinem Sauerstoff geflutet.

2. Verfahren nach Anspruch 1,
dadurch gekennzeichnet, daß
zur Orientierung der Textur in Richtung der c-Achse oder in Richtung der beiden Zylinderachsen die Form der Rohlinge gemäß dem Verhältnis Zylinderdurchmesser : Zylinderhöhe > 2 festgelegt wird, wobei die Höhe auf < 25 mm beschränkt bleibt.

3. Verfahren nach Anspruch 2,
dadurch gekennzeichnet, daß
die Rohlinge für den zweiten, weiteren Verdichtungsvorgang hermetisch abgeschlossen in Folie eingeschweißt werden und die isostatische Verdichtung in einer kompressiblen Flüssigkeit wie Öl oder inkompressiblen Flüssigkeit wie Wasser erfolgt.

## Claims

1. Method of producing optimised, melt-textured volume samples based on the high-temperature superconductor YBa₂Cu₃O₇ (YBCO) for use in contact-less, self-stabilising magnetic bearings, which method comprises the following method steps:
a) preparing the starting material:
commercially available powder of the compounds YBa₂Cu₃O₇₋ₓ, Y₂O₃ and PtO₂ is ground as the starting material, this being in such a manner that the YBa₂Cu₃O₇ powder has a particle size in the region of d₅₀ = 10 ± 2 µm, and, in consequence, the specific surface is substantially 1 ± 0.2 m²/g, the oxygen content x being < 0.2, and the external phase proportion being < 1 %, carbon occurring at most with 2000 ppm, and the transition metals possibly occurring in the sum with 2000 ppm at most,
the Y₂O₃ powder has a particle size in the region of d = 4.5 µm,
and
the PtO₂ powder has a particle size in the region of d = 60 µm,
b) quantitative preparation for the desired texturing:
the three powder types are processed further for an optimum texturising process in proportions according to the stoichiometry of the compound
YBa₂Cu₃O₇ + 0.35 mol% Y₂O₃ + 0.1 wt.% PtO₂
and intermixed in a ball mill within a prescribed time until a uniform blending is achieved, the intermixing time being limited to an undesirable CO₂ absorption, or the three powder types are intermixed in an inert gas atmosphere in the ball mill until the envisaged uniform blending is achieved,
the prepared powder is uniaxially pressed into a prescribed configuration and compacted into blanks of a prescribed configuration under a high pressure of at least 300 bar,
the blanks are packed to prevent their surfaces from being contaminated, and they are compacted further by cold, isostatic pressing with at least 3000 bar, whereby the powder particles come into close contact with one another,
c) melting process:
the blanks are textured in an isothermal chamber oven according to the temperature behaviour of Figure 4 prescribed with respect to time,
seed crystals are introduced in situ into the molten mass during the phase of the first drop in temperature with respect to time at a prescribed temperature, the seed temperature,
prior to the cooling-down phase to the ambient temperature, the temperate in the interior of the oven is kept constant for a prescribed time, and the oven is flooded with pure oxygen at the beginning of this process.

2. Method according to claim 1, characterised in that, to orientate the texture in the direction of the c axis or in the direction of the two cylinder axes, the configuration of the blanks is set according to the cylinder diameter : cylinder height ratio > 2, the height remaining limited to < 25 mm.

3. Method according to claim 2, characterised in that the blanks for the second, additional compacting operation are welded into film in a hermetically sealed manner, and the isostatic compaction is effected in a compressible liquid, such as oil, or in an incompressible liquid, such as water.

## Revendications

1. Procédé de fabrication d'échantillons en volume, optimisés, structurés par fusion, à base de supraconducteurs à haute température YBa₂Cu₃O₇ (YBCO) destiné à des applications dans des paliers magnétiques autostabilisants, sans contact, comprenant les étapes suivantes :
a) préparation de la matière de départ :
• comme poudre de départ, on utilise une poudre du commerce de la combinaison YBa₂Cu₃O₇₋ₓ, Y₂O₃ et PtO₂ que l'on broie, cela de façon que la poudre YBa₂Cu₃O₇ présente une granulométrie de l'ordre de d₅₀ = 10 ± 2 µm et ainsi une surface superficielle spécifique d'environ 1 + 2 m²/g,
• la teneur en oxygène x < 0,2 et la teneur en phase étrangère < 1 %,
• le carbone étant présent au maximum selon 2000 ppm et les métaux de transition avec une somme globale maximale égale à 2000 ppm,
• la poudre Y₂O₃ a une granulométrie de l'ordre de d = 4,5 µm et,
• la poudre PtO₂ a une granulométrie de l'ordre de d = 60 µm,
b) préparation quantitative pour la texturation souhaitée :
• on travaille les trois types de poudre pour un procédé de texturation optimum selon des teneurs correspondant à la stoechiométrie de la relation :
YBa₂Cu₃O₇ + 0,35 Mol % Y₂o₃ + 0,1 % PtO₂
• on mélange dans un broyeur à billes pendant une durée prédéterminée jusqu'à obtenir un mélange régulier,
• la durée de mélange étant limitée jusqu'à une prise gênante de CO₂ ou encore les trois sortes de poudre sont mélangées dans une atmosphère de gaz inerte dans le broyeur à billes jusqu'à atteindre le mélange régulier prévu,
• la poudre préparée est comprimée uniquement axialement pour prendre une forme prédéterminée et elle est densifiée sous une pression élevée au moins 300 bars pour donner des ébauches de forme prédéterminée,
• les ébauches sont emballées pour protéger leur surface superficielle contre la contamination et subissent une compression isostatique à froid d'au moins 3000 bars pour que les grains de poudre arrivent en contact étroit ;
c) procédé de fusion :
• on texture les ébauches selon un profil de température prédéterminé dans le temps selon la figure 4 dans un four à chambre isotherme,
• pendant la phase de la première chute de température dans le temps, à une température prédéterminée dite température d'ensemencement, on introduit les cristaux de semence in situ dans le produit fondu,
• avant la phase de refroidissement à la température ambiante, on maintient constante la température à l'intérieur du four pendant une durée prédéterminée et on ventile le four avec de l'oxygène pur au début de ce procédé.

2. Procédé selon la revendication 1,
caractérisé en ce que
pour orienter la texture dans la direction de l'axe (c) ou dans la direction des deux axes de cylindre, on limite la forme des ébauches selon le rapport diamètre du cylindre/hauteur du cylindre > 2, la hauteur étant limitée à < 25 mm.

3. Procédé selon la revendication 2,
caractérisé en ce que
les ébauches pour la seconde autre opération de compression sont soudées dans une feuille fermée hermétiquement et on effectue la compression isostatique dans un liquide comprimable tel que de l'huile ou un liquide incompressible tel que de l'eau.
